# FASCICULE DE BREVET EUROPEEN

(11) **EP 3 486 211 B1**
(45) Date de publication et mention de la délivrance du brevet: **18.06.2025**
(21) Numéro de dépôt: 18206004.6
(22) Date de dépôt: 13.11.2018
(51) Int. Cl.: F21S 41/40, F21S 45/10, G02B 5/00, G02B 26/08

(54) **MODULE D'ÉCLAIRAGE POUR PROJECTEUR DE VÉHICULE AUTOMOBILE**
BELEUCHTUNGSMODUL FÜR KRAFTFAHRZEUGSCHEINWERFER
LIGHTING MODULE FOR HEADLIGHTS OF A MOTOR VEHICLE

(30) Priorité: 17.11.2017 FR 1760841
(43) Date de publication de la demande: 22.05.2019
(73) Titulaire: Valeo Vision, 93012 Bobigny Cedex (FR)
(72) Inventeur: CHOQUET, Pierre, 93012 BOBIGNY Cedex (FR); DANIEL, Thomas, 93012 BOBIGNY Cedex (FR)
(74) Mandataire: Valeo Visibility

(56) Documents cités:
- WO-A1-2017/143372
- WO-A1-2017/147632
- US-A1- 2002 056 900
- US-A1- 2004 041 988
- US-A1- 2006 268 243
- US-A1- 2008 158 892
- US-A1- 2009 135 564
- US-A1- 2015 092 435

## Description

### Domaine technique de l'invention

La présente invention concerne un module d'éclairage pour un projecteur d'un véhicule automobile, le module d'éclairage comprenant une matrice de micro-miroirs. L'invention concerne également un projecteur pour véhicule automobile comprenant un tel module d'éclairage. L'invention concerne également un véhicule automobile comprenant un tel projecteur ou un tel module d'éclairage.

### État de la technique

Pour l'éclairage des véhicules automobiles, on connaît l'utilisation de modules d'éclairage comprenant une source lumineuse et une matrice de micro-miroirs. Une matrice de micro-miroirs est un microsystème électromécanique comprenant une multitude de micro-miroirs qui sont tous mobiles autour d'un même axe et qui peuvent prendre au moins deux orientations distinctes. Selon sa première orientation, un micro-miroir transmet un rayon lumineux hors du module d'éclairage, dans un champ d'éclairage. Selon sa deuxième orientation, le rayon lumineux est dévié hors du champ d'éclairage et est absorbé par une structure du module d'éclairage. L'orientation de chaque micro-miroir peut être commandée individuellement par l'effet d'une force électrostatique. Le module d'éclairage comprend un circuit de commande relié à une unité de commande électronique. L'unité de commande électronique émet un courant de commande à destination de chacun des micro-miroirs pour définir leur orientation.

De tels projecteurs permettent de composer et de projeter des images complexes devant le véhicule. Ils sont donc utilisés pour réaliser différentes fonctions telles que par exemple la projection d'informations utiles à la sécurité de piétons situés aux abords directs du véhicule, ou encore par exemple une fonction d'éclairage de la route évitant l'éblouissement des autres automobilistes.

Lors de son fonctionnement, un tel module d'éclairage peut s'échauffer fortement. Un échauffement excessif peut conduire à un disfonctionnement, voire à la destruction, de la matrice de micro-miroirs ou de son circuit de commande. Afin de refroidir la matrice de micro-miroirs, on connaît l'utilisation de dissipateurs thermiques et de ventilateurs. Toutefois, ces moyens de refroidissement sont volumineux et insuffisamment performants pour maintenir le module d'éclairage en dessous d'une température d'endommagement.

Le document WO 2017/147632 A1 divulgue un module d'éclairage pour un projecteur d'automobile selon le préambule de la revendication 1.

### Objet de l'invention

Le but de l'invention est de fournir un module d'éclairage remédiant aux inconvénients ci-dessus et améliorant les modules d'éclairage connus de l'art antérieur. En particulier, l'invention permet de réaliser un module d'éclairage qui soit compact, simple à mettre en œuvre et qui limite l'échauffement de la matrice de micro-miroirs ou de son circuit de commande.

L'invention porte sur un module d'éclairage pour un projecteur d'un véhicule automobile, le module d'éclairage comprenant une source lumineuse et une matrice de micro-miroirs, comprenant un masque interposé entre la source lumineuse et la matrice de micro-miroirs, le masque comprenant une ouverture laissant passer des rayons lumineux issus de la source lumineuse et orientés vers la matrice de micro-miroirs, le masque comprenant une partie opaque bloquant des rayons lumineux issus de la source lumineuse et non-orientés vers la matrice de micro-miroirs, et la matrice de micro-miroirs s'étendant selon un premier plan et le masque s'étendant selon un deuxième plan, le premier plan et le deuxième plan étant sensiblement parallèles, l'ouverture du masque étant positionnée sensiblement à l'aplomb de la matrice de micro-miroirs caractérisé en ce que les micro-miroirs sont mobiles individuellement entre une orientation active et une orientation inactive, les micro-miroirs réfléchissant des rayons lumineux issus de la source lumineuse au travers de l'ouverture du masque lorsqu'ils sont dans leur orientation active, les micro-miroirs réfléchissant des rayons lumineux issus de la source lumineuse contre la partie opaque du masque lorsqu'ils sont dans leur orientation inactive, et en ce que la partie opaque du masque comprend une surépaisseur, les micro-miroirs réfléchissant des rayons lumineux issus de la source lumineuse contre ladite surépaisseur lorsqu'ils sont dans leur orientation inactive.

Le module d'éclairage peut comprendre une puce supportant la matrice de micro-miroirs, la puce comprenant une surface apparente positionnée autour de la matrice de micro-miroirs et non destinée à réfléchir des rayons lumineux hors du module d'éclairage, la partie opaque du masque bloquant des rayons lumineux issus de la source lumineuse et orientés vers la surface apparente.

L'ouverture peut avoir une forme homothétique à une forme de la matrice de micro-miroirs.

L'ouverture peut avoir une forme sensiblement rectangulaire, une largeur de l'ouverture étant comprise entre 4mm et 10mm, voire comprise entre 6mm et 8mm, et une longueur de l'ouverture étant comprise entre 5mm et 15mm, voire comprise entre 8mm et 12mm.

La surface de l'ouverture peut être supérieure ou égale à la surface de la matrice de micro-miroirs, voire supérieure ou égale au double de la surface de la matrice de micro-miroirs et/ou la surface de l'ouverture peut être inférieure ou égale au quadruple de la surface de la matrice de micro-miroirs, voire inférieure ou égale au triple de la surface de la matrice de micro-miroirs.

Le module d'éclairage peut comprendre un collimateur de lumière interposé entre la source lumineuse et le masque, un faisceau lumineux issu du collimateur illuminant l'ouverture du masque.

Le module d'éclairage peut comprendre au moins un moyen de dissipation de la chaleur, notamment un ventilateur et/ou un dissipateur thermique. Le masque peut supporter un moyen de dissipation de la chaleur, notamment un ventilateur et/ou un dissipateur thermique.

L'invention porte également sur un projecteur comprenant un module d'éclairage tel que défini précédemment.

L'invention porte également sur un véhicule automobile comprenant un module d'éclairage tel que défini précédemment ou un projecteur tel que défini précédemment.

### Description sommaire des dessins

Ces objets, caractéristiques et avantages de la présente invention seront exposés en détail dans la description suivante d'un mode de réalisation particulier fait à titre non-limitatif en relation avec les figures jointes parmi lesquelles :
La figure 1 est une vue schématique d'un véhicule automobile selon un mode de réalisation de l'invention.
La figure 2 est une vue isométrique d'un projecteur selon un mode de réalisation de l'invention.
La figure 3 est une première vue isométrique partielle d'un module d'éclairage muni d'une matrice de micro-miroirs.
La figure 4 est une deuxième vue isométrique partielle du module d'éclairage.
La figure 5 est une vue isométrique d'un masque selon un mode de réalisation de l'invention.
La figure 6 est une vue d'une puce comprenant une matrice de micro-miroirs.
La figure 7 est une vue schématique du module d'éclairage, des micro-miroirs étant dans une orientation active.
La figure 8 est une vue schématique du module d'éclairage, des micro-miroirs étant dans une orientation inactive.

### Description de modes préférentiels de l'invention

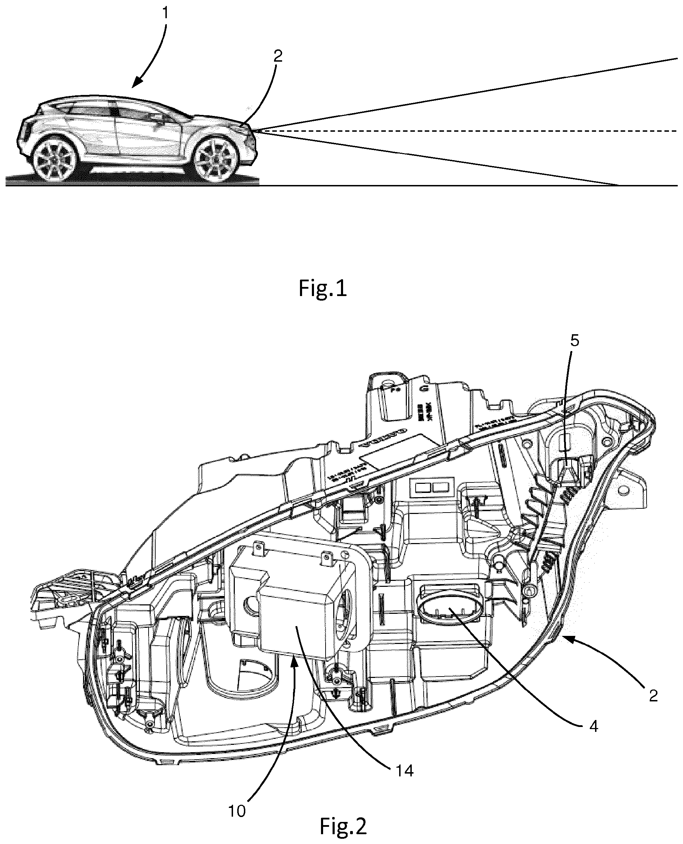

La figure 1 illustre un véhicule 1 automobile muni d'un projecteur 2 selon un mode de réalisation de l'invention. Le véhicule peut être de toute nature, par exemple il peut s'agir d'un véhicule particulier, d'un véhicule utilitaire ou d'un camion. Le projecteur 2 est disposé à l'avant du véhicule mais pourrait aussi bien équiper l'arrière du véhicule. Le projecteur permet d'éclairer la route, d'être vu des autres automobilistes et/ou de projeter sur le sol des images fournissant des informations au conducteur ou à son environnement.

La figure 2 illustre le projecteur 2. Le projecteur 2 comprend un boîtier 3 contenant un module d'éclairage 10 muni d'une matrice de micro-miroirs 21 ainsi que des trous 4, 5 pour d'autres dispositifs lumineux. Le module d'éclairage 10 peut réaliser différentes fonctions lumineuses du projecteur tels que par exemple produire un feu de position, un feu de croisement, un feu de route, un feu antibrouillard ou encore un clignotant.

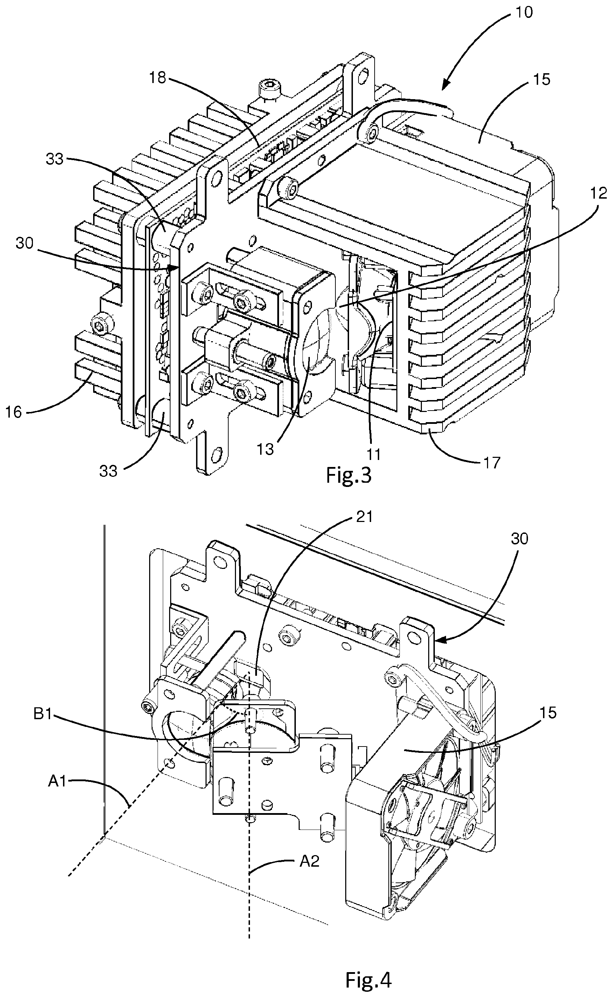

Les figures 3 et 4 illustrent plus précisément le module d'éclairage 10 muni de la matrice de micro-miroirs 21. Le module d'éclairage 10 comprend une source lumineuse 11, en l'occurrence une diode électroluminescente, un collimateur 12 et un système optique de projection 13. La source lumineuse 11 et le collimateur 12 sont agencés de manière à ce que des rayons lumineux issus de la source lumineuse traversent le collimateur 12 puis soient dirigés vers la matrice de micro-miroirs 21. Les rayons lumineux peuvent être ensuite réfléchis par la matrice de micro-miroirs 21 et traverser le système optique de projection 13. Le collimateur 12 et le système optique de projection 13 peuvent comprendre une ou plusieurs lentilles optiques. Un boîtier de protection 14, visible uniquement sur la figure 2, peut être fixé sur le module d'éclairage pour le protéger. Ce boîtier de protection est ajouré au niveau du système optique de projection 13 pour laisser sortir les rayons lumineux.

Comme représenté sur la figure 4, on peut définir un premier axe optique A1 passant par le centre du système optique de projection 13, c'est-à-dire passant par le centre de la ou des lentilles optiques qui le compose. De même, on peut définir un deuxième axe optique A2 passant par le centre du collimateur, c'est-à-dire passant par le centre de la ou des lentilles optiques qui le compose. Le premier axe optique A1 et le deuxième axe optique A2 définissent le parcours d'un rayon lumineux passant par le centre du collimateur et par le centre du système optique de projection 13. L'angle B1 formé entre l'axe A1 et l'axe A2 peut être environ égal à 24° ou à toute autre valeur permettant un agencement adéquat du collimateur et de l'optique de projection dans le module d'éclairage.

En outre, le module d'éclairage 10 comprend des moyens de dissipations de la chaleur. Ces moyens de dissipation de la chaleur sont notamment un ventilateur 15, un premier dissipateur thermique 16 positionné dans une partie arrière du module d'éclairage, à l'opposé du système optique de projection 13 et du collimateur 12, et un deuxième dissipateur thermique 17 positionné autour du collimateur 12.

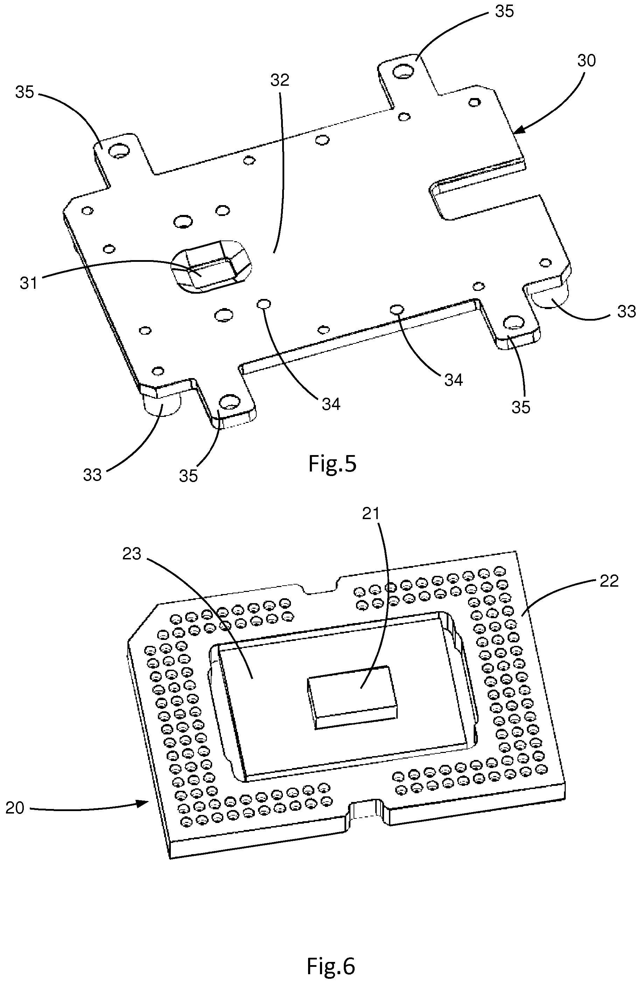

La matrice de micro-miroirs 21 est un microsystème électromécanique comprenant une multitude de micro-miroirs plats qui sont tous mobiles indépendamment autour d'un même axe. Les micro-miroirs peuvent prendre deux orientations distinctes de 24°. L'orientation de chaque micro-miroir peut être commandée individuellement par l'effet d'une force électrostatique. Chaque micro-miroir peut être de forme carrée avec une longueur de côté d'environ 7µm. Les micro-miroirs peuvent être espacés d'environ 0,5 µm les uns des autres. La matrice de micro-miroirs présente une forme rectangulaire avec une largeur d'environ 3.5mm et une longueur d'environ 7mm et peut comprendre plusieurs centaines de micro-miroirs sur la largeur et plusieurs centaines de micro-miroirs sur la longueur. La matrice de micro-miroirs 21 est intégrée à une puce 20 de plus grande dimension illustrée sur la figure 6. La puce 20 a également une forme rectangulaire et peut avoir une largeur d'environ 22mm et une longueur d'environ 32mm. La puce comprend la matrice de micro-miroirs en son centre et une interface de connexion 22 sur un pourtour extérieur. Une surface apparente 23 s'étend entre la matrice de micro-miroirs 21 et l'interface de connexion 22. Seule la matrice de micro-miroirs 21 est destinée à réfléchir la lumière issue de la source lumineuse. La surface apparente 23 ne comprend pas de micro-miroirs. La puce 20 et notamment la matrice de micro-miroirs sont particulièrement sensibles à la température. Pour garantir un fonctionnement correct, la température de la puce et de la matrice de micro-miroirs ne doit pas excéder une température seuil, par exemple une température de 68°C.

Selon une première orientation, dite orientation active, un micro-miroir réfléchit un rayon lumineux provenant de la source lumineuse 11 vers le système optique de projection 13. C'est-à dire le rayon lumineux traverse le système optique de projection 13 et émerge du projecteur pour éclairer la route ou l'environnement du véhicule. Selon une deuxième orientation, dite orientation inactive, un micro-miroir réfléchit un rayon lumineux provenant de la source lumineuse 11 ailleurs que vers le système optique de projection 13. C'est-à-dire le rayon lumineux ne traverse pas le système optique de projection 13 et ne sert pas à une fonction d'éclairage.

Le module d'éclairage comprend également un circuit imprimé 18 sur lequel est fixée la puce 20 supportant la matrice de micro-miroirs 21. Le circuit imprimé, la puce et la matrice de micro-miroirs s'étendent selon des plans parallèles entre eux et perpendiculaires au premier axe optique A1. Le circuit imprimé 18 comprend des pilotes électroniques permettant de commander la matrice de micro-miroirs. L'unité de commande électronique émet une commande définissant quels micro-miroirs sont orientés selon la première orientation et quels micro-miroirs sont orientés selon la deuxième orientation. La commande est émise à la matrice de micro-miroir via le circuit imprimé et la puce. Ainsi, chaque micro-miroir définit un pixel d'une image complexe : la matrice de micro-miroirs peut ainsi être non seulement utilisée pour obtenir un éclairage standardisé mais aussi pour projeter des images complexes.

Le module d'éclairage comprend un masque 30 interposé entre la source lumineuse et la matrice de micro-miroirs. Selon le mode de réalisation représenté, le masque est même interposé entre le collimateur 12 et la matrice de micro-miroirs 21. Le masque comprend une ouverture 31 laissant passer des rayons lumineux issus de la source lumineuse et orientés vers la matrice de micro-miroirs. Le masque comprend une partie opaque 32 bloquant des rayons lumineux issus de la source lumineuse et non-orientés vers la matrice de micro-miroirs, c'est-à-dire orientés ailleurs que vers la matrice de micro-miroirs. Par « bloquant », on comprend que les rayons lumineux peuvent être absorbés ou réfléchis par la partie opaque. Un rayon lumineux qui serait orienté vers le circuit imprimé 18 ou vers la puce 20 autour de la matrice de micro-miroirs, notamment vers la surface apparente 23, serait ainsi bloqué par la partie opaque 32 du masque. La trajectoire d'un rayon lumineux réfléchi par le masque ne rencontre ni la matrice de micro-miroirs, ni la puce à laquelle la matrice de micro-miroirs est fixée, ni le circuit imprimé sur lequel la puce est fixée. Préférentiellement, les rayons lumineux réfléchis par le masque ne pénètrent pas dans le système optique de projection 13 mais sont dirigés vers une zone non fonctionnelle du module d'éclairage où ils finiront par être absorbés. En variante la partie opaque pourrait être translucide ou transparente et dévier (plutôt que bloquer) les rayons lumineux pour que ceux-ci ne heurtent ni la matrice de micro-miroirs, ni la puce, ni le circuit imprimé.

Le masque 30, particulièrement visible sur les figures 3 et 5, s'étend selon un plan sensiblement parallèle au plan de la matrice de micro-miroirs, de la puce et du circuit imprimé. Le masque peut être une platine de forme globalement rectangulaire de taille voisine de celle du circuit imprimé. Une longueur du masque peut être par exemple de l'ordre de 100mm et une largeur du masque peut être de l'ordre de 65mm. L'ouverture 31 du masque est également de forme rectangulaire et à une longueur de l'ordre de 10mm et une largeur de l'ordre de 7mm. Le rapport de la surface de l'ouverture 31 sur la surface de la matrice de micro-miroir 21 est donc d'environ 2,8 ou 2,9. L'ouverture 31 est plus grande que la matrice de micro-miroirs 21 mais plus petite que la puce 20. L'ouverture du masque est positionnée sensiblement à l'aplomb de la matrice de micro-miroirs, sur la trajectoire des rayons lumineux issus du collimateur 12 et dirigés vers la matrice de micro-miroirs. La taille de l'ouverture est suffisante pour que d'une part toute la matrice de micro-miroirs puisse être illuminée par la source lumineuse et d'autre part pour que tous les rayons lumineux réfléchis par des micro-miroirs en orientation active puissent ressortir par cette même ouverture 31.

Le faisceau lumineux en sortie du collimateur a une section sensiblement circulaire jusqu'à ce qu'il parvienne à l'ouverture 31. Avantageusement, le collimateur est défini de sorte que la section circulaire du faisceau lumineux au niveau du masque corresponde à un cercle circonscrit au rectangle de l'ouverture 31. Au delà de l'ouverture 31 le faisceau lumineux à une section rectangulaire. Le masque à donc une fonction de mise en forme du faisceau lumineux. L'image projetée par le module d'éclairage a une forme rectangulaire et ses proportions sont sensiblement identiques à celle de la matrice de micro-miroirs.

Avantageusement, l'ouverture 31 a une forme homothétique de celle de la matrice de micro-miroirs 21. C'est-à-dire que le rectangle dessiné par l'ouverture 31 et le rectangle dessiné par la matrice de micro-miroirs 21 sont orientés de la même manière et ont des proportions sensiblement identiques. Dans l'hypothèse ou la matrice de micro-miroirs aurait une forme différente, par exemple circulaire ou polygonale, la forme de l'ouverture serait donc adaptée en conséquence. Avantageusement, on peut tenir compte de l'angle B1 définissant un angle d'incidence des rayons lumineux sur le masque pour adapter les proportions de l'ouverture du masque. Ainsi l'ouverture 31 du masque est définie de sorte que le faisceau lumineux en aval de cette ouverture (c'est-à-dire au delà de cette ouverture) éclaire la totalité et uniquement la totalité de la matrice de micro-miroirs 21. Afin de tenir compte des tolérances géométriques du module d'éclairage, le faisceau lumineux pourra éclairer une surface légèrement plus grande que celle de la matrice de micro-miroirs.

Le masque 30 est fixé contre le circuit imprimé par l'intermédiaire d'entretoises 33 permettant de définir un espacement régulier entre le circuit imprimé et le masque. L'espace entre le masque et le circuit imprimé peut être compris entre 5mm et 10mm. Le masque sert également de support pour fixer le système optique de projection 13, le collimateur 12, le deuxième dissipateur thermique 19 et le ventilateur 17. A cet effet, le masque comprend différents trous de fixation 34 au travers desquelles passent des vis de fixation pour le système optique de projection 13, le collimateur 12 et le deuxième dissipateur thermique 19. On précise que ces trous de fixations 34 se distinguent de ladite ouverture en ce qu'ils ne sont pas destinés à laisser passer de la lumière mais des vis de fixation. Le masque comprend également des appendices 35 permettant de fixer le boitier 14 et l'ensemble du module d'éclairage 10 au sein du projecteur 2.

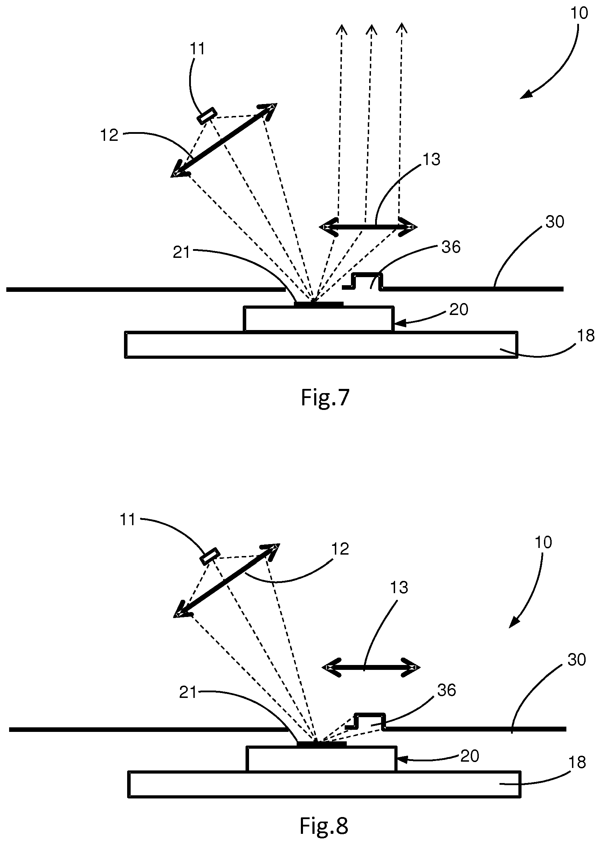

D'une part, les micro-miroirs réfléchissent les rayons lumineux issus de la source lumineuse au travers de l'ouverture du masque lorsqu'ils sont dans leur orientation active. D'autre part, les micro-miroirs réfléchissent les rayons lumineux issus de la source lumineuse contre la partie opaque du masque lorsqu'ils sont dans leur orientation inactive. Les rayons lumineux sont soit absorbés par le masque, soit réfléchis par le masque et donc confinés dans l'espace séparant le masque du circuit imprimé. A proximité de l'ouverture, le masque comprend une surépaisseur 36 représentée schématiquement sur les figures 7 et 8. La surépaisseur 36 est positionnée sur la trajectoire des rayons lumineux lorsqu'ils sont réfléchis par des micro-miroirs en orientation inactive. Le masque peut être réalisé par exemple en plastique ou en aluminium de manière à conduire la chaleur vers les moyens de dissipation de la chaleur. Le masque 30 est donc susceptible de s'échauffer mais il est également efficacement refroidi car le ventilateur 15 et le deuxième dissipateur thermique 17 sont fixés directement contre le masque. De plus, le masque est réalisé dans un matériau résistant à la température et/ou ayant de bonnes propriétés de conduction de la chaleur. Les entretoises 33 permettent de maintenir le masque chaud à une distance maitrisée de la puce 20 et du circuit imprimé 18.

La figure 7 illustre le fonctionnement du module d'éclairage. La source lumineuse émet un rayon lumineux qui traverse le collimateur (schématisé par une unique lentille optique sur la figure 7). Le rayon lumineux traverse ensuite l'ouverture et est réfléchi par au moins un micro-miroir en orientation active. Le rayon lumineux retraverse l'ouverture et rentre dans le système optique (schématisé par une unique lentille optique sur la figure 7). Le rayon lumineux ressort du système optique sensiblement parallèlement au premier axe optique A1.

La figure 8 illustre le fonctionnement du module d'éclairage. La source lumineuse émet un rayon lumineux qui traverse le collimateur (schématisé par une unique lentille optique sur la figure 7). Le rayon lumineux traverse ensuite l'ouverture et est réfléchi par un micro-miroir en orientation inactive. Le rayon lumineux rencontre la partie opaque du masque, notamment la surépaisseur 36. Le rayon lumineux est absorbé par le masque et est converti en chaleur. La chaleur est évacuée du masque grâce aux moyens de dissipation de la chaleur, notamment le ventilateur 15 et le dissipateur thermique 17.

Naturellement, un fonctionnement du module d'éclairage avec une partie des micro-miroirs en orientation active et l'autre partie des micro-miroirs en orientation inactive est possible.

Grâce à l'invention, le masque remplit plusieurs fonctions : avant tout, il empêche la lumière issue de la source lumineuse de chauffer inutilement la matrice de micro-miroirs et/ou la puce et ne laisse passer que les rayons lumineux utiles, c'est-à-dire ceux qui impactent la matrice de micro-miroirs. La puce 20 et le circuit imprimé 18 n'absorbent pas ou très peu de rayons lumineux, ce qui minimise leur échauffement. Le masque permet également de bloquer les rayons lumineux réfléchis par les micro-miroirs en orientation inactive. Enfin, le masque évacue la chaleur produite par l'absorption des rayons lumineux à distance de la matrice de micro-miroirs et il forme un support pour solidariser différents composants essentiels du module d'éclairage. La température de la puce et/ou de la matrice de micro-miroirs peut être ainsi abaissée de 10°C à 30°C comparativement à un module d'éclairage identique sans masque.

## Revendications

1. Module d'éclairage (10) pour un projecteur (2) d'un véhicule (1) automobile, le module d'éclairage (10) comprenant une source lumineuse (11) et une matrice de micro-miroirs (21), comprenant un masque (30) interposé entre la source lumineuse (11) et la matrice de micro-miroirs (21), le masque comprenant une ouverture (31) laissant passer des rayons lumineux issus de la source lumineuse (11) et orientés vers la matrice de micro-miroirs (21), le masque (30) comprenant une partie opaque (32) bloquant des rayons lumineux issus de la source lumineuse (11) et non-orientés vers la matrice de micro-miroirs (21), et la matrice de micro-miroirs (21) s'étendant selon un premier plan et le masque (30) s'étendant selon un deuxième plan, le premier plan et le deuxième plan étant sensiblement parallèles, l'ouverture (31) du masque (30) étant positionnée sensiblement à l'aplomb de la matrice de micro-miroirs (21) **caractérisé en ce que** les micro-miroirs (21) sont mobiles individuellement entre une orientation active et une orientation inactive, les micro-miroirs réfléchissant des rayons lumineux issus de la source lumineuse au travers de l'ouverture (31) du masque (30) lorsqu'ils sont dans leur orientation active, les micro-miroirs (21) réfléchissant des rayons lumineux issus de la source lumineuse (11) contre la partie opaque (32) du masque (30) lorsqu'ils sont dans leur orientation inactive, et **en ce que** la partie opaque (32) du masque (30) comprend une surépaisseur (36), les micro-miroirs réfléchissant des rayons lumineux issus de la source lumineuse (11) contre ladite surépaisseur (36) lorsqu'ils sont dans leur orientation inactive.

2. Module d'éclairage (10) selon la revendication précédente, **caractérisé en ce qu'**il comprend une puce (20) supportant la matrice de micro-miroirs (21), la puce (20) comprenant une surface apparente (23) positionnée autour de la matrice de micro-miroirs (21) et non destinée à réfléchir des rayons lumineux hors du module d'éclairage, la partie opaque (32) du masque (30) bloquant des rayons lumineux issus de la source lumineuse (11) et orientés vers la surface apparente (23).

3. Module d'éclairage (10) selon l'une des revendications précédentes, **caractérisé en ce que** l'ouverture (31) a une forme homothétique à une forme de la matrice de micro-miroirs (21).

4. Module d'éclairage (10) selon l'une des revendications précédentes, **caractérisé en ce que** l'ouverture (31) à une forme sensiblement rectangulaire, une largeur de l'ouverture étant comprise entre 4mm et 10mm, voire comprise entre 6mm et 8mm, et une longueur de l'ouverture étant comprise entre 5mm et 15mm, voire comprise entre 8mm et 12mm.

5. Module d'éclairage (10) selon l'une des revendications précédentes, **caractérisé en ce que** la surface de l'ouverture (31) est supérieure ou égale à la surface de la matrice de micro-miroirs (21), voire supérieure ou égale au double de la surface de la matrice de micro-miroirs (21) et/ou **en ce que** la surface de l'ouverture (31) est inférieure ou égale au quadruple de la surface de la matrice de micro-miroirs (21), voire inférieure ou égale au triple de la surface de la matrice de micro-miroirs (21).

6. Module d'éclairage (10) selon l'une des revendications précédentes, **caractérisé en ce qu'**il comprend un collimateur (12) de lumière interposé entre la source lumineuse (11) et le masque (30), un faisceau lumineux issu du collimateur (12) illuminant l'ouverture (31) du masque.

7. Module d'éclairage (10) selon l'une des revendications précédentes, **caractérisé en ce qu'**il comprend au moins un moyen de dissipation de la chaleur, notamment un ventilateur (15) et/ou un dissipateur thermique (17).

8. Module d'éclairage (10) selon la revendication précédente, **caractérisé en ce que** le masque (30) supporte un moyen de dissipation de la chaleur, notamment un ventilateur (15) et/ou un dissipateur thermique (17).

9. Projecteur (2) comprenant un module d'éclairage (10) selon l'une des revendications précédentes.

10. Véhicule automobile, **caractérisé en ce qu'**il comprend un module d'éclairage selon l'une des revendications 1 à 8 ou un projecteur selon la revendication précédente.

## Patentansprüche

1. Beleuchtungsmodul (10) für einen Scheinwerfer (2) eines Kraftfahrzeugs (1), wobei das Beleuchtungsmodul (10) eine Lichtquelle (11) und ein Mikrospiegel-Array (21) umfasst, umfassend eine Maske (30), die zwischen der Lichtquelle (11) und dem Mikrospiegel-Array (21) angeordnet ist, wobei die Maske eine Öffnung (31) umfasst, die aus der Lichtquelle (11) hervorgegangene und zu dem Mikrospiegel-Array (21) gerichtete Lichtstrahlen durchlässt, wobei die Maske (30) einen undurchlässigen Teil (32) umfasst, der aus der Lichtquelle (11) hervorgegangene und nicht zu dem Mikrospiegel-Array (21) gerichtete Lichtstrahlen blockiert, und wobei sich das Mikrospiegel-Array (21) entlang einer ersten Ebene erstreckt und wobei sich die Maske (30) entlang einer zweiten Ebene erstreckt, wobei die erste Ebene und die zweite Ebene im Wesentlichen parallel sind, wobei die Öffnung (31) der Maske (30) im Wesentlichen lotrecht zu dem Mikrospiegel-Array (21) positioniert ist, **dadurch gekennzeichnet, dass** die Mikrospiegel (21) einzeln zwischen einer aktiven Ausrichtung und einer inaktiven Ausrichtung beweglich sind, wobei die Mikrospiegel aus der Lichtquelle hervorgegangene Lichtstrahlen durch die Öffnung (31) der Maske (30) hindurch reflektieren, wenn sie in ihrer aktiven Ausrichtung sind, wobei die Mikrospiegel (21) aus der Lichtquelle (11) hervorgegangene Lichtstrahlen gegen den undurchlässigen Teil (32) der Maske (30) reflektieren, wenn sie in ihrer inaktiven Ausrichtung sind, und dadurch, dass der undurchlässige Teil (32) der Maske (30) eine Verdickung (36) umfasst, wobei die Mikrospiegel aus der Lichtquelle (11) hervorgegangene Lichtstrahlen gegen die Verdickung (36) reflektieren, wenn sie in ihrer inaktiven Ausrichtung sind.

2. Beleuchtungsmodul (10) nach dem vorhergehenden Anspruch, **dadurch gekennzeichnet, dass** es einen Chip (20) umfasst, der das Mikrospiegel-Array (21) trägt, wobei der Chip (20) eine sichtbare Fläche (23) umfasst, die um das Mikrospiegel-Array (21) positioniert ist und nicht dazu bestimmt ist, Lichtstrahlen aus dem Beleuchtungsmodul heraus zu reflektieren, wobei der undurchlässige Teil (32) der Maske (30) aus der Lichtquelle (11) hervorgegangene und zu der sichtbaren Fläche (23) gerichtete Lichtstrahlen blockiert.

3. Beleuchtungsmodul (10) nach einem der vorhergehenden Ansprüche, **dadurch gekennzeichnet, dass** die Öffnung (31) eine homothetische Form mit einer Form des Mikrospiegel-Arrays (21) hat.

4. Beleuchtungsmodul (10) nach einem der vorhergehenden Ansprüche, **dadurch gekennzeichnet, dass** die Öffnung (31) eine im Wesentlichen rechteckige Form hat, wobei eine Breite der Öffnung zwischen 4 mm und 10 mm oder sogar zwischen 6 mm und 8 mm beträgt und wobei eine Länge der Öffnung zwischen 5 mm und 15 mm oder sogar zwischen 8 mm und 12 mm beträgt.

5. Beleuchtungsmodul (10) nach einem der vorhergehenden Ansprüche, **dadurch gekennzeichnet, dass** die Fläche der Öffnung (31) größer oder gleich der Fläche des Mikrospiegel-Arrays (21) oder sogar größer oder gleich dem Zweifachen der Fläche des Mikrospiegel-Arrays (21) ist, und/oder dadurch, dass die Fläche der Öffnung (31) kleiner oder gleich dem Vierfachen der Fläche des Mikrospiegel-Arrays (21) oder sogar kleiner oder gleich dem Dreifachen der Fläche des Mikrospiegel-Arrays (21) ist.

6. Beleuchtungsmodul (10) nach einem der vorhergehenden Ansprüche, dass es einen Kollimator (12) für Licht umfasst, der zwischen der Lichtquelle (11) und der Maske (30) angeordnet ist, wobei ein aus dem Kollimator (12) hervorgegangener Lichtstrahl die Öffnung (31) der Maske beleuchtet.

7. Beleuchtungsmodul (10) nach einem der vorhergehenden Ansprüche, **dadurch gekennzeichnet, dass** es mindestens ein Mittel zum Ableiten der Wärme umfasst, insbesondere ein Gebläse (15) und/oder einen Kühlkörper (17).

8. Beleuchtungsmodul (10) nach dem vorhergehenden Anspruch, **dadurch gekennzeichnet, dass** die Maske (30) ein Mittel zum Ableiten der Wärme trägt, insbesondere ein Gebläse (15) und/oder einen Kühlkörper (17).

9. Scheinwerfer (2), umfassend ein Beleuchtungsmodul (10) nach einem der vorhergehenden Ansprüche.

10. Kraftfahrzeug, **dadurch gekennzeichnet, dass** es ein Beleuchtungsmodul nach einem der Ansprüche 1 bis 8 oder einen Scheinwerfer nach dem vorhergehenden Anspruch umfasst.

## Claims

1. Lighting module (10) for a projector (2) of a motor vehicle (1), the lighting module (10) comprising a light source (11) and a matrix of micromirrors (21), comprising a mask (30) disposed between the light source (11) and the matrix of micromirrors (21), the mask comprising an opening (31) allowing light rays coming from the light source (11) to pass and oriented towards the matrix of micromirrors (21), and the mask (30) comprising an opaque part (32) blocking light rays coming from the light source (11) and not oriented toward the matrix of micromirrors (21) and the matrix of micromirrors (21) extends in a first plane and in that the mask (30) extends in a second plane, the first plane and the second plane being substantially parallel, the opening (31) of the mask (30) being positioned substantially in vertical alignment with the matrix of micromirrors (21) reflecting light rays coming from the light source (11) against the opaque part (32) of the mask (30) when they are in their inactive orientation, in that the opaque part (32) of the masque (30) comprises an overthickness (36), the micromirrors reflecting light rays coming from the light source (11) against said overthickness (36) when they are in their inactive orientation.

2. Lighting module (10) according to the preceding claim, **characterized in that** it comprises a microchip (20) supporting the matrix of micromirrors (21), the microchip (20) comprising an apparent surface (23) positioned around the matrix of micromirrors (21) and not intended to reflect light rays out of the lighting module, the opaque part (32) of the mask (30) blocking light rays coming from the light source (11) and oriented toward the apparent surface (23).

3. Lighting module (10) according to any one of the preceding claims, **characterized in that** the opening (31) has a shape homothetic to a shape of the matrix of micromirrors (21).

4. Lighting module (10) according to any one of the preceding claims, **characterized in that** the opening (31) has a substantially rectangular shape, a width of the opening being between 4 mm and 10 mm inclusive, or even between 6 mm and 8 mm inclusive, and a length of the opening being between 5 mm and 15 mm inclusive, or even between 8 mm and 12 mm inclusive.

5. Lighting module (10) according to any one of the preceding claims, **characterized in that** the area of the opening (31) is greater than or equal to the area of the matrix of micromirrors (21), or even greater than or equal to twice the area of the matrix of micromirrors (21) and/or in that the area of the opening (31) is less than or equal to four times the area of the matrix of micromirrors (21), or even less than or equal to three times the area of the matrix of micromirrors (21).

6. Lighting module (10) according to any one of the preceding claims, **characterized in that** it comprises a light collimator (12) disposed between the light source (11) and the mask (30), a light beam coming from the collimator (12) illuminating the opening (31) of the mask.

7. Lighting module (10) according to any one of the preceding claims, **characterized in that** it comprises at least one heat dissipation means, notably a fan (15) and/or a heatsink (17).

8. Lighting module (10) according to the preceding claim, **characterized in that** the mask (30) supports a heat dissipation means, notably a fan (15) and/or a heatsink (17).

9. Projector (2) comprising a lighting module (10) according to any one of the preceding claims.

10. Motor vehicle, **characterized in that** it comprises a lighting module according to any one of Claims 1 to 8 or a projector according to the preceding claim.
